## Europäisches Patentamt
## European Patent Office
## Office européen des brevets

(19)

(11) Numéro de publication: **0 199 621**
**B1**

(12) **FASCICULE DE BREVET EUROPEEN**

(45) Date de publication du fascicule du brevet:
11.07.90

(51) Int. Cl.⁵: **H05K 7/20**

(21) Numéro de dépôt: **86400645.7**

(22) Date de dépôt: **26.03.86**

(54) **Connecteur thermique pour carte de circuit imprimé revêtue de composants électroniques.**

(30) Priorité: **16.04.85 FR 8505715**

(43) Date de publication de la demande:
**29.10.86 Bulletin 86/44**

(45) Mention de la délivrance du brevet:
**11.07.90 Bulletin 90/28**

(84) Etats contractants désignés:
**DE GB IT**

(56) Documents cités:
**EP-A- 0 091 335**
**FR-A- 2 514 601**
**US-A- 4 298 904**
**US-A- 4 322 776**

(73) Titulaire: **SOCAPEX, 10 bis, quai Léon Blum,
F-92153 Suresnes(FR)**

(72) Inventeur: **Bricaud, Hervé, 5, rue de Saint-Germain,
F-78370 Plaisir(FR)**
Inventeur: **Bertho, Dominique, 54, rue Galilée,
F-78500 Sartrouville(FR)**

(74) Mandataire: **Hasenrader, Hubert et al, Cabinet BEAU DE
LOMENIE 55, rue d'Amsterdam, F-75008 Paris(FR)**

ACTORUM AG

# Description

La présente invention concerne un connecteur thermique pour carte de circuit imprimé revêtue de composants électroniques dissipant des calories, ce connecteur étant destiné plus particulièrement aux armoires électroniques comportant une grande densité de cartes.

En effet, le problème de la connexion thermique se pose notamment dans les appareils ou équipements électriques comportant un grand nombre de cartes munies de composants électroniques; car, parmi ces composants, certains d'entre-eux dissipent une quantité de chaleur importante qu'il convient d'évacuer dans les meilleures conditions possibles afin de maintenir lesdits composants dans des conditions de fonctionnement acceptables. On sait, par exemple, que les circuits intégrés comportent de plus en plus de fonctions et d'éléments intégrés sur la puce semiconductrice et que la quantité de chaleur dissipée augmente corrélativement. Afin de ne pas endommager lesdits circuits ou réduire leur durée de vie leur température de jonction en fonctionnement ne doit pas dépasser environ 125°C, aussi il convient d'évacuer le plus rapidement possible les calories dissipées par ces circuits.

Pour réaliser cette fonction, on utilise en général des cartes de circuit imprimé munies d'un substrat thermoconducteur. De telles cartes sont décrites notamment dans la demande de brevet européen EP-A 0 090 727 au nom de la Demanderesse. Ces cartes sont en général, montées dans des connecteurs qui relient le substrat thermoconducteur de la carte à la ou les parois froides de l'équipement électronique à refroidir. Les parois froides véhiculent alors les calories vers le puits thermique du système. Dans le cas des connecteurs thermiques décrits ci-dessus la chaîne de conduction thermique comporte les maillons suivants :

– la résistance de couplage du boîtier sur la carte,
– la résistance de conduction transversale de la carte,
– la résistance de conduction longitudinale du substrat thermoconducteur de la carte, qui est d'autant plus élevée que les dimensions de la carte sont grandes,
– la résistance de couplage des bords latéraux du substrat thermoconducteur sur les parois froides de l'équipement, et
– la résistance de conduction du bâti de l'équipement entre les parois froides et le puits thermique.

Cette chaîne de conduction thermique est relativement longue. Aussi, pour qu'en particulier le dernier maillon n'altère pas de façon trop importante l'évacuation des calories dissipées par le système, les dimensions des équipements recevant ce type de connecteur doivent être limitées à quelques dizaines de centimètres et l'électronique doit être concentrée dans un volume restreint. Ces contraintes sont donc incompatibles avec le volume des armoires électroniques telles que, par exemple, les baies des équipements de télécommunication ou même les nouvelles générations de gros satellites pour lesquels les parties électroniques situées au centre se trouvent trop éloignées de la paroi froide extérieure qui rayonne les calories dans l'espace.

On connaît du US-A 4 298 904 un connecteur thermique pour carte de circuit imprimé, cette carte portant au moins un composant électronique dissipant de la chaleur et comportant un substrat thermoconducteur. Ce connecteur comprend une paroi réalisée en matériau bon conducteur thermique, contre laquelle une partie du substrat thermoconducteur est reçue en contact direct, et le connecteur comprend un conduit de circulation pour un fluide caloporteur.

Dans la mesure où le connecteur comporte de telles parois suivant un espacement régulier, il n'est pas possible de régler l'espacement entre les cartes voisines.

La présente invention a pour but de remédier à ces inconvénients en fournissant un connecteur thermique conforme à la revendication 1.

Dans ce cas, la chaîne de conduction thermique comporte les maillons suivants:

– la résistance de couplage des composants sur le substrat conducteur,
– la résistance de conduction transversale du substrat de la carte,
– la résistance de conduction longitudinale du substrat thermoconducteur, et
– la résistance de couplage des bords latéraux du substrat thermoconducteur directement sur le puits thermique.

Selon un mode de réalisation préférentiel, le moyen formant puits thermique est constitué par un échangeur thermique par circulation d'un fluide caloporteur réalisé par un bloc prolongeant ladite paroi thermoconductrice, ledit bloc étant muni de moyens permettant la circulation du fluide caloporteur. De préférence, les moyens permettant la circulation du fluide caloporteur sont constitués par au moins un conduit percé dans ledit bloc, conduit qui est raccordé à des canalisations d'amenée et d'évacuation dudit fluide.

Pour réaliser le raccordement fluidique entre chaque conduit et l'une des canalisations d'amenée ou d'évacuation du fluide caloporteur, de préférence le bloc est muni de moyens sécants et perpendiculaires au conduit permettant le passage de la canalisation correspondante et la canalisation et le conduit sont munis chacun d'orifices de diamètre adéquat permettant le raccordement fluidique de la canalisation et du conduit.

Selon un premier mode de réalisation la canalisation est munie d'au moins un orifice de diamètre sensiblement égal à celui du conduit et le bloc comporte un trou de diamètre supérieur à celui de la canalisation, sécant et perpendiculaire au conduit, ledit trou étant destiné à recevoir avec interposition d'un moyen d'étanchéité, l'une des canalisations d'amenée ou d'évacuation du fluide caloporteur de telle sorte que l'orifice de la canalisation soit en communication avec le conduit.

Selon un autre mode de réalisation, les canalisations sont constituées par des tubes de section rectangulaire ou carré munis sur une face d'au moins un orifice de diamètre sensiblement égal à celui du conduit, et le bloc est muni d'une gorge sécante et perpendiculaire au conduit, la section de la gorge permettant de recevoir avec interposition d'un moyen d'étanchéïté ladite canalisation avec son orifice en communication avec le conduit, un moyen de retenu maintenant en place la canalisation dans la gorge.

Les deux modes de raccordement fluidique décrits ci-dessus sont particulièrement bien adaptés au cas de plusieurs connecteurs thermiques conformes à la présente invention alimentés en parallèle.

Selon une autre caractéristique de la présente invention, la face de la carte de circuit imprimé opposée à celle qui est en contact avec la paroi thermoconductrice est au contact de moyens de maintien solidaires du conducteur qui la plaque contre ladite paroi.

D'autres caractéristiques et avantages de la présente invention apparaîtront à la lecture de la description de divers modes de réalisation faite avec référence aux dessins ci-annexés dans lesquels :

- la figure 1 est une vue en coupe d'un connecteur thermique conforme à la présente invention en position connectée sur le substrat thermoconducteur de la carte ;
- la figure 2 est une vue en perspective d'une partie d'une alvéole d'une baie électronique équipée de connecteurs thermiques conforme à la présente invention ;
- la figure 3 est vue en élévation latérale montrant la fixation du connecteur thermique sur la structure de l'alvéole de la baie représentée à la figure 2;
- la figure 4 est une vue en coupe partielle d'un premier mode de réalisation du raccordement fluidique étanche du connecteur thermique sur le réseau de canalisation de l'équipment ;
- la figure 5 est une vue en coupe partielle d'un autre mode de réalisation du raccordement fluidique étanche du connecteur thermique sur le réseau de canalisation de l'équipement ;
- les figures 6a, 6b et 6c sont des représentations schématiques des différentes possibilités de circulation du fluide caloporteur dans l'ensemble des collecteurs thermiques de l'équipement.

Pour simplifier la description, sur les différentes figures, les mêmes éléments portent les mêmes références.

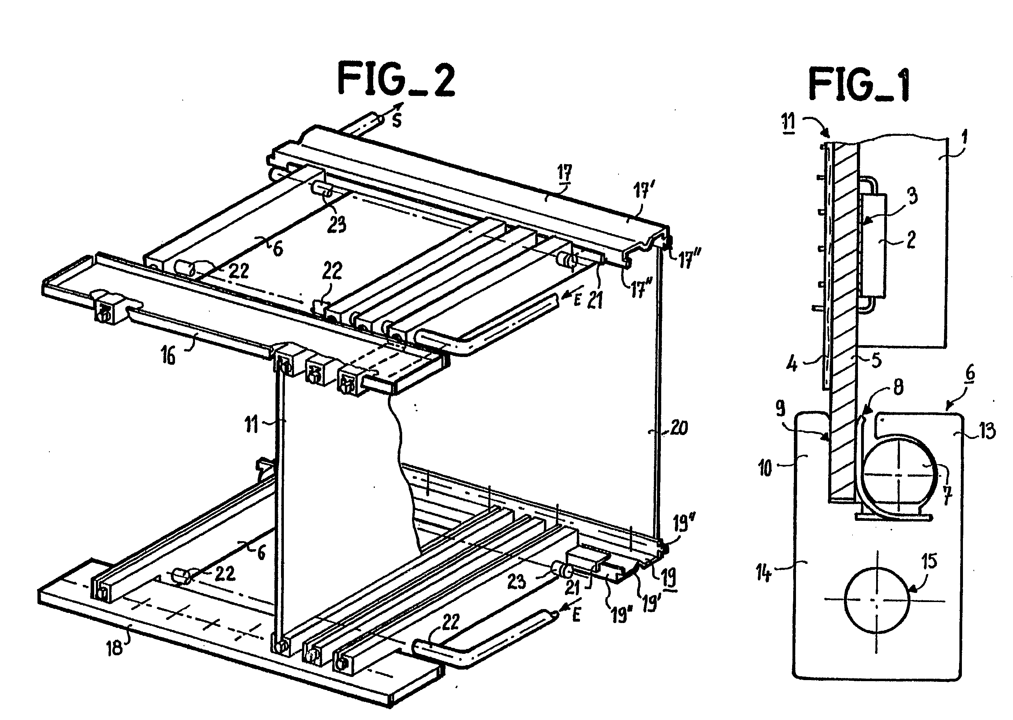

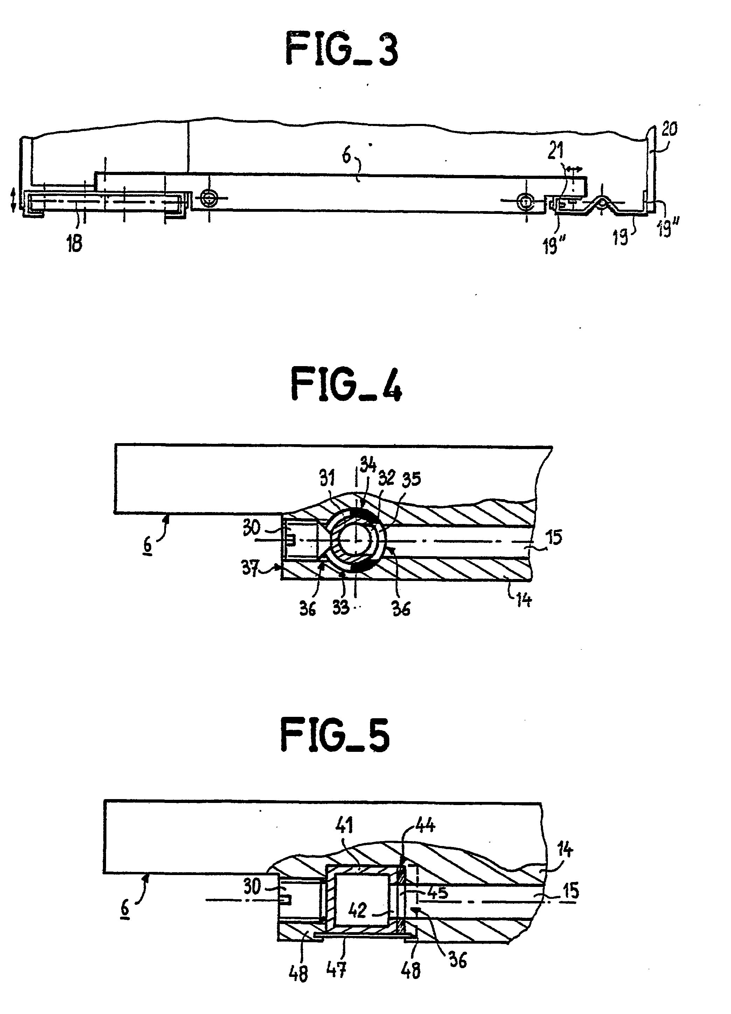

Sur la figure 1, on a représenté une carte à substrat thermoconducteur montée dans un connecteur électrique conforme à la présente invention. Cette carte à substrat thermoconducteur est constituée essentiellement d'un circuit imprimé 4 revêtue d'un drain thermique 5 et munie d'un composant électrique 2 dissipant une grande quantité de chaleur. Entre le composant 2 et le drain thermique 5 est intercalé un joint thermique 3 qui est une pâte conductrice facilitant le transfert des calories entre le composant et le drain. Le drain thermique 5 est enfiché dans le connecteur thermique 6 qui comporte deux parois sensiblement verticales 10 et 13 reliées, conformément à la présente invention, par un bloc 14 muni d'un conduit 15 dont le rôle sera expliqué ci-après. La paroi verticale 10 est au contact du drain thermique 5 le long de sa face 9. Le drain 5 est placé contre la face 9 par l'intermédiaire d'un moyen de maintien solidaire du connecteur constitué, dans le mode de réalisation représenté, d'un contact élastique 8 s'appuyant sur l'autre face du drain, contact élastique qui est maintenu en position par une came rotative 7 qui suivant son orientation permet l'introduction du drain thermique dans le connecteur ou son maintien dans celui-ci. Dans la position représentée sur la figure 1, la came maintient le drain thermique au contact de la paroi 9. Ce type de moyen de maintien est bien connu de l'homme de l'art et a été décrit notamment dans la demande de brevet française N° 82.05250 au nom de la Demanderesse. Toutefois, d'autres types de moyen de maintien peuvent être envisagés.

D'autre part, le conduit 15 du bloc 15 est percé sur toute la longueur dudit bloc et sert à la circulation d'un fluide caloporteur, réalisant ainsi un échangeur thermique au sein du connecteur. On notera donc que, dans ce cas, le chemin de conduction thermique entre la face 9 du drain thermique de la carte et le puits thermique constitué par le conduit 15 de circulation de fluide caloporteur est le plus court possible et ceci tout au long de la carte. Par ailleurs, entre la paroi verticale 10 sur laquelle sont couplés le drain 5 de la carte et le puits thermique 15, il n'y a aucun raccordement parasite entraînant une résistance de couplage thermique supplémentaire puisque la paroi 15 et le bloc 14 forment en général une seule et même pièce monobloc. Cet ensemble sera donc réalisé dans une matière bonne conductrice de la chaleur telle que, par exemple, l'aluminium ou l'un de ses alliages. D'autre part, sa forme sera obtenue, par exemple, par extrusion à travers une filière présentant le profil du monobloc constitué par les parois 10 et 13 et le bloc 14 percé du conduit 15.

En ce qui concerne la nature du fluide caloporteur, celui-ci sera de préférence un liquide et pourra être par exemple choisi parmi l'eau, les alcools tels que l'éthanol ou l'éthylèneglycol, les fluorocarbonés tels que le trichlorotrifluoronéthane, les huiles de lubrification, de refroidissement, les huiles minérales, l'essence, le kérosène, etc. Ce fluide pourra êtra prélevé sur un circuit de fluide disponible dans l'équipement ou bien issu d'un réservoir de fluide caloporteur spécial.

Sur la figure 2 est représentée une vue d'ensemble en perspective d'une alvéole d'une baie électronique équipée de connecteurs thermiques à circulation de fluide conformes à la présente invention. La structure générale de l'alvéole est bien connue de l'homme de l'art. Elle est réalisée, dans ce mode de réalisation, en technologie mécano-soudée à l'aide de pièces en tôle d'acier pliée jouant respectivement le rôle de barreaux supérieur 16 et inférieur 18 et de traverses supérieure 17 et inférieure 19. Les traverses supérieure 17 et inférieure 19 sont constituées par des profilés sensiblement en U et comportent une âme centrale 17', 19' et deux ailes verticles 17", 19". Les connecteurs thermiques 6 conformes à la présente invention viennent se fixer sur l'une des ailes verticales de la traverse supérieure ou de la traverse inférieure par l'intermédiaire d'une cornière en L 21 qui permet un réglage longitudinal et vertical du connecteur dans l'alvéole comme représenté sur la figure 3. De manière plus précise, la cornière 21 vient se fixer sur la traverse supérieure ou inférieure de manière à présenter une partie horizontale sur laquelle repose une des extrémités du connecteur thermique. La fixation est réalisée à l'aide de vis que permettent le réglage longitudinal et vertical du connecteur par rapport à la traverse. D'autre part, l'autre extrémité du connecteur thermique 6 vient se fixer sur la partie plane du barreau supérieur 16 ou inférieur 18 qui présente généralement la forme d'un profilé en C. La carte mère 20 qui joue le rôle de fond de panier, sur laquelle sont électriquement connectées la ou les cartes filles 11, est fixée à l'arrière de l'alvéole sur les autres ailes verticales 17", 19" des traverses 17 et 19.

Comme représenté sur la figure 2, plusieurs connecteurs thermiques 6 conformes à la présente invention sont vissés à chacune de leurs extrémités respectivement sur le barreau 16 ou 18 et la traverse 17 ou 19 constituant ainsi une rangée supérieure et une rangée inférieure de connecteurs en vis-à-vis et parallèles les uns aux autres. Le pas entre deux connecteurs consécutifs est fonction de l'épaisseur des composants de la carte fille 11 correspondante et peut être variable le long de l'alvéole. Toutefois, la répartition du pas des connecteurs est symétrique pour les rangées inférieure et supérieure d'une même alvéole.

D'autre part, comme représenté sur la figure 2, chaque rangée supérieure ou inférieure de connecteurs thermiques conforme à la présente invention est raccordée respectivement à une canalisation d'amenée 22 et d'évacuation 23 de fluide caloporteur. Dans le mode de réalisation représenté, le raccordement des connecteurs thermiques est un raccordement en parallèle toutefois d'autres types de raccordement peuvent être envisagés comme cela sera expliqué de manière plus détaillée ci-après.

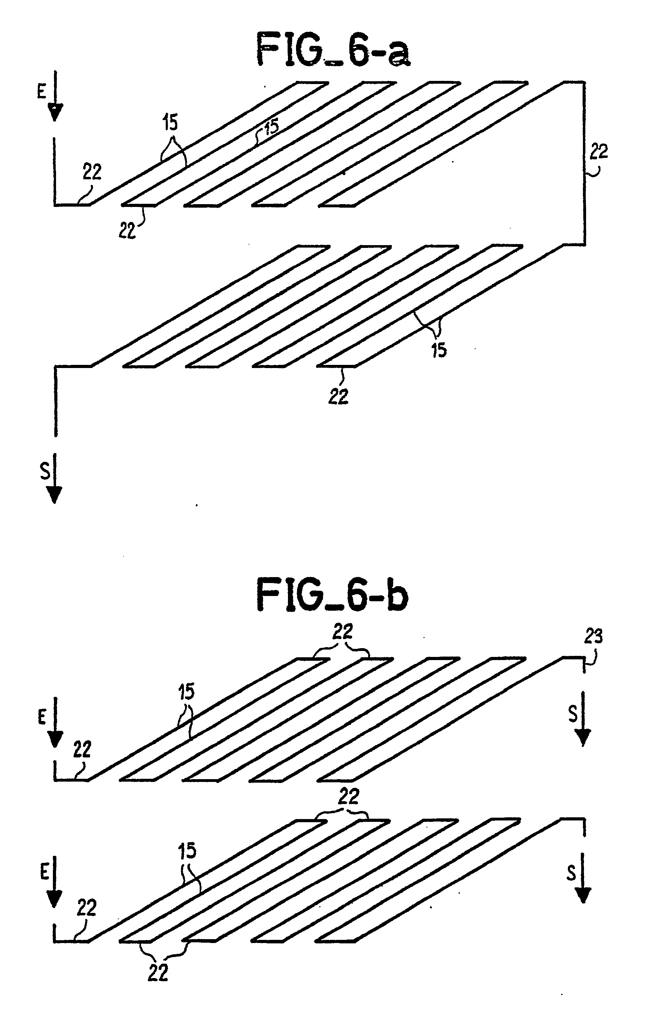

Pour réaliser le raccordement des canalisations d'amenée ou d'évacuation du fluide caloporteur avec le conduit de circulation de fluide caloporteur percé dans le bloc du connecteur thermique de la présente invention, différents modes de raccordement fluidique peuvent être envisagés. Deux modes de réalisation particuliers ont été représentés respectivement sur les figures 4 et 5.

Selon le mode de réalisation représenté sur la figure 4, un trou 33 de diamètre supérieur à celui du conduit 15 est percé dans le bloc 14 du connecteur thermique 6 près de l'extrémité 36 dudit conduit mais légèrement en retrait de l'extrémité 37 dudit bloc 14. Ce trou 33 est sécant et perpendiculaire au conduit 15. Dans le cas où les connecteurs thermiques sont connectés en parallèle sur les canalisations d'amenée ou d'évacuation de fluide caloporteur comme représenté sur la figure 2, le trou 33 traverse tout le bloc 14. Toutefois, dans le cas où les connecteurs thermiques sont connectés en série, comme cela sera expliqué ci-après, le trou 33 s'arrête au niveau du conduit 15. La partie du conduit 15 comprise entre le trou 33 et l'extrémité 37 la plus proche du bloc 14 est filetée de manière à recevoir une vis de blocage 30 dont le rôle sera expliqué ci-après. D'autre part, la canalisation d'amenée ou d'évacuation du fluide caloporteur comporte au moins un orifice de communication 32 de diamètre proche de celui-ci du conduit 15. Dans le mode de réalisation de la figure 2, les canalisations d'amenée 21 et d'évacuation 23 comporteront des orifices distribués sur toutes leurs longueurs selon le pas des connecteurs thermiques de la rangée supérieure ou inférieure. Ainsi, la canalisation d'amenée ou d'évacuation de fluide caloporteur, qui a de préférence un diamètre légèrement supérieur au conduit 15 et légèrement inférieur au trou 33 est introduite dans le trou 33 et placée de telle façon que son orifice de communication 32 vienne en vis-à-vis de l'orifice 36 du conduit 15. D'autre part, un joint d'étanchéité 34 percé d'un orifice 35 équivalent à l'orifice 32 est convenablement intercalé entre la canalisation et la paroi interne du trou 33 de façon à ce que les orifices 32 et 35 coïncident avec l'orifice 36. La vis de blocage 39 est alors serrée en portant directement sur la canalisation de manière à presser celle-ci sur le joint 34 pour assurer l'étanchéité du raccordement fluidique entre la canalisation et le conduit 15 du connecteur thermique 6.

Un mode de réalisation préférentiel du raccordement fluidique entre les canalisations et le conduit 15 est représenté sur la figure 5. Dans ce cas, une gorge de section rectangulaire ou carrée a été usinée dans le bloc 15 près de l'extrémité du conduit 15 mais légèrement en retrait de l'extrémité du bloc 14. Cette gorge est sécante et perpendiculaire au conduit 15. Dans ce cas, les canalisations d'amenée ou d'évacuation du fluide caloporteur sont constituées par des tubes 41 de section rectangulaire ou carrée comme représenté sur la figure 5. Ces tubes sont munis d'un orifice 42 sur une de leurs faces, orifice qui présente un diamètre sensiblement équivalent à celui de l'orifice 36 du conduit 15. La canalisation 41 est introduite dans la gorge du bloc 14 pour que son orifice 42 coïncide avec l'orifice 36 avec interposition d'un joint d'étanchéité 44 muni d'un orifice 45 qui coïncide aussi avec l'orifice 36. La canalisation 41 est maintenue en position dans la gorge par l'intermédiaire d'un clips de retenu 47 qui s'engage dans deux saignées 48 prévues dans le bloc 14. D'autre part, la vis de pression 30 insérée dans l'extrémité du conduit 15 qui a été filetée comme pour le mode de réalisation de la figure 5, permet de presser en position la canalisation 41 contre le conduit 15. Ce mode de raccordement fluidique possède un certain nombre d'avantages. En effet, le positionnement de l'orifice de circulation de fluide du connecteur thermique en face de l'orifice de la canalisation d'alimentation est simplifié du fait de la suppression de la rotation du tube d'alimentation. De plus, le joint d'étanchéité se positionne immédiatement à l'aide de deux lèvres s'appuyant sur les flancs du connecteur thermique. D'autre part, on a un démontage et un remontage rapides du connecteur thermique sans démontage de l'ensemble des canalisations et une mise en place rapide d'obturateurs dans le cas d'utilisation de guides cartes à la place des connecteurs thermiques.

D'autres types de raccordement fluidique peuvent être envisagés sans sortir du cadre de la présente invention. De plus, les deux types de raccordement fluidique décrits ci-dessus peuvent être modifiés de manière évidente pour l'homme de l'art pour s'adapter aux types de circulation adoptés pour le fluide caloporteur.

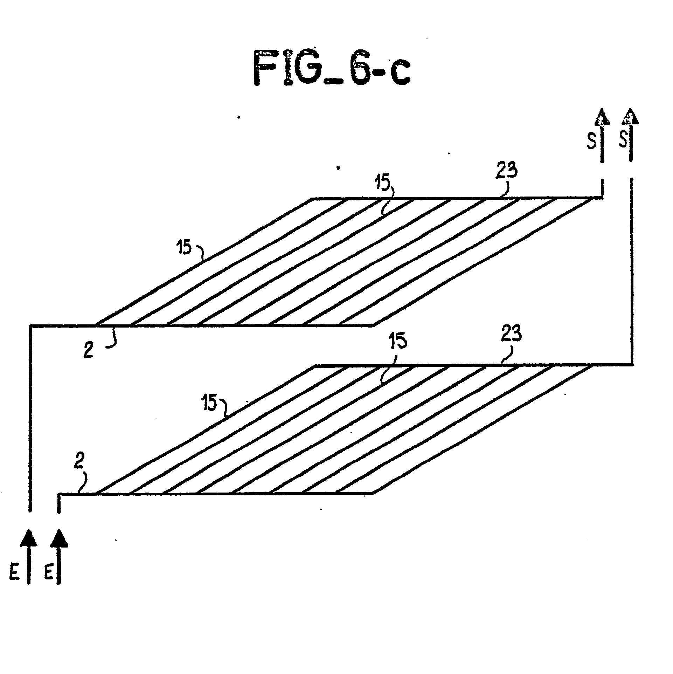

Comme représenté sur les figures 6a à 6c, différentes solutions peuvent être envisagées pour la circulation du fluide caloporteur au sein d'une alvéole. Dans la configuration représentée sur la figure 6a, le fluide caloporteur traverse successivement les connecteurs thermiques de la partie supérieure de l'alvéole puis les connecteurs thermiques de la partie inférieure de l'alvéole. Dans ce cas, chaque élément étant monté en série, la perte de charge totale du circuit est égale à la somme des pertes de charge de l'ensemble des éléments. D'autre part, dans cette configuration, le fluide traverse les connecteurs thermiques de la partie supérieure de l'alvéole puis ceux de la partie inférieure de l'alvéole. En traversant chaque connecteur thermique la température du fluide va augmenter. En conséquence, les températures du fluide circulant dans les connecteurs thermiques supérieur et inférieur d'une même carte sont différentes et l'évacuation thermique dépend de la position de la carte de circuit imprimé dans l'alvéole.

Dans la configuration de la figure 6b, les alimentations des connecteurs thermiques supérieur et inférieur sont indépendantes. Le fluide caloporteur traverse successivement chaque connecteur thermique, et le problème des pertes de charge sera identique à celui de la figure 6a au niveau d'une rangée sans effet cumulatif. Toutefois, dans ce cas la température du fluide caloporteur traversant le connecteur thermique supérieur et celle du fluide caloporteur traversant le connecteur thermique inférieur d'une même carte devraient être identiques, mais l'évacuation thermique dépend toujours de la position de la carte de circuit imprimé dans l'alvéole.

Dans la configuration de la figure 6c, l'alimentation de la rangée supérieure des connecteurs thermiques est indépendante de celle de la rangée inférieure, le fluide caloporteur passe simultanément dans tous les connecteurs thermiques qui sont alimentés en parallèle au niveau de chaque rangée. Comme chaque élément est monté en parallèle, la perte de charge est identique pour chaque élément et le fluide traverse simultanément tous les éléments dans une configuration de perte de charge minimale. La température du fluide caloporteur est donc identique quelque soit le connecteur thermique à puissance dissipée égale sur les cartes. En ce qui concerne l'évacuation thermique, elle est indépendante de la position de la carte de circuit imprimé dans l'alvéole. D'autre part, les alimentations de la rangée supérieure et de la rangée inférieure de connecteurs thermiques étant indépendantes, la température du fluide caloporteur traversant les connecteurs thermiques d'une même carte doit être identique.

Les connecteurs thermiques conformes à la présente invention présentent de nombreux avantages. En particulier, il permet d'accroître considérablement les possibilités d'extraction des calories dissipées dans l'alvéole. En effet, le puits thermique de chaque carte dissipante est alors amené au ras de ses bords latéraux ce qui réduit de façon importante les résistances de la chaîne de conduction thermique entre le composant qui dissipe sur la carte et le puits thermique constitué par le fluide caloporteur qui circule dans le conduit 15 tout le long du bloc 14 du connecteur 6. D'autre part, comme la largeur des connecteurs 6 est sensiblement identique à celle des guides-cartes plastiques traditionnels ou des connecteurs thermiques actuellement utilisés, l'utilisation de connecteurs thermiques conformes à la présente invention n'affecte en rien les conditions de refroidissement par convection de l'alvéole, un tel refroidissement se superposant au refroidissment principal apporté par les connecteurs thermiques 6 à circulation de fluide. De plus, la conception modulaire de ces connecteurs permet de les mélanger au sein d'une même alvéole avec des guides-cartes plastiques ou des connecteurs thermiques actuellement utilisés afin d'optimiser l'équipement sur le plan économique en affectant les connecteurs thermiques de la présente invention uniquement aux cartes qui dissipent une puissance élevée.

**Revendications**

1. Connecteur thermique pour carte de circuit imprimé (11), ladite carte portant au moins un composant électronique (2) dissipant de la chaleur et comportant un substrat thermoconducteur (5), ledit connecteur comprenant au moins une paroi (10) réalisée en matériau bon conducteur thermique, contre laquelle une partie (9) du substrat thermoconducteur est reçue en contact direct, et le connecteur comprenant au moins un conduit (15) de circulation d'un fluide caloporteur, caractérisé en ce que le connecteur a la forme d'une pièce allongée dans laquelle la paroi (10) est prolongée par un bloc (14) formant avec elle un ensemble monobloc, ledit conduit (15) s'étendant longitudinalement dans ledit bloc (14), ledit connecteur recevant une seule carte et comprenant des moyens individuels de maintient en position sur un support, et ledit connecteur comprenant au moins un moyen d'amenée de fluide en communication avec ledit conduit (15) et au moins un moyen d'évacuation de fluide en communication avec ledit conduit (15), lesdits moyens étant raccordés à des canalisations (22, 23) d'amenée et d'évacuation de fluide.

2. Connecteur thermique selon la revendication 1, caractérisé en ce que les moyens permettant la circulation d'un fluide caloporteur sont constitués par au moins un conduit (15) percé dans ledit bloc.

3. Connecteur thermique selon la revendication 2, caractérisé en ce que, pour réaliser le raccordement fluidique entre chaque conduit et l'une des canalisations d'amenée ou d'évacuation du fluide caloporteur, la canalisation (31) est munie d'au moins un orifice (32) de diamètre sensiblement égal à celui du conduit (13) et le bloc comporte un trou (33) de diamètre supérieur à celui de la canalisation, sécant et perpendiculaire au conduit, ledit trou étant destiné à recevoir avec interposition d'un moyen d'étanchéité (34) l'une des canalisations de telle sorte que l'orifice de la canalisation (32) soit en communication avec le conduit (15).

4. Connecteur thermique selon la revendication 3, caractérisé en ce que le moyen d'étanchéité est constitué par un joint annulaire (34) muni sur une paroi d'un orifice (35) de diamètre sensiblement égal à celui de l'orifice de la canalisation.

5. Connecteur thermique selon la revendication 3, caractérisé en ce que, pour réaliser le raccordement fluidique entre chaque conduit et l'une des canalisations d'amenée et d'évacuation du fluide caloporteur, les canalisations (41) sont constituées par des tubes de section rectangulaire ou carré munis sur une face d'au moins un orifice (42) de diamètre sensiblement égal à celui du conduit (15) et le bloc est muni d'une gorge sécante et perpendiculaire au conduit, la section de la gorge permettant de recevoir avec interposition d'un moyen d'étanchéité ladite canalisation avec son orifice en communication avec le conduit, un moyen de tetenue (47) maintenant en place la canalisation dans la gorge.

6. Connecteur thermique selon l'une quelconque des revendications 3 et 5, caractérisé en ce que le conduit se prolonge entre le trou ou la gorge et l'extrémité du bloc par une partie de conduit destinée à recevoir un moyen (30) permettant le serrage en position de la canalisation (31, 41).

7. Connecteur thermique selon l'une quelconque des revendications 1 à 6, caractérisé en ce que la face de la carte opposée à celle qui est en contact avec la paroi est au contact de moyens (7, 8) de maintien, solidaires du connecteur, qui la plaque contre ladite paroi.

## Claims

1. Thermal connector for printed circuit board (11), said board carrying at least one electronic component (2) dissipating heat and comprising a heat-conducting substrate (5), said connector comprising at least one wall (10) made from a material which is a good heat-conductor, against which wall a part (9) of the heat-conducting substrate is received in direct contact, and the connector comprising at least one duct (15) for circulating a heat-carrying fluid, characterized in that the shape of the connector is that of an elongated piece in which the wall (10) is extended by a block (14) forming a monobloc assembly therewith, said duct (15) extending longitudinally inside said block (14), said connector receiving only one board and comprising individual retention means keeping it in position on a support and said connector comprising at least one fluid admission means in communication with said duct (15) and at least one fluid evacuation means in communication with said duct (15), said means being connected with fluid admission and evacuation channels (22, 23).

2. Thermal connector according to claim 1, characterized in that the means permitting the circulation of a heat-carrying fluid are constituted by at least one duct (15) provided in said block.

3. Thermal connector according to claim 2, characterized in that to achieve the fluidic connection between each duct and one of the heat-carrying fluid admission or evacuation channels, channel (31) is provided with at least one orifice (32) of diameter substantially equal to that of duct (13) and the block comprises a hole (33) of diameter greater than that of the channel, secant and perpendicular to the duct, said hole being intended to receive, with interposition of a sealing means (34) one of the channels such that the orifice of channel (32) is in communication with duct (15).

4. Thermal connector according to claim 3, characterized in that the sealing means is constituted by an annular washer (34) provided, on a wall, with an orifice (35) of diameter substantially equal to that of the orifice of the channel.

5. Thermal connector according to claim 3, characterized in that, to achieve the fluidic connection between each duct and one of the heat-carrying fluid admission and evacuation channels, the channels (41) are constituted by tubes of rectangular or square cross-section, provided on one face with at least one orifice (42) of diameter substantially equal to that of duct (15) and the block is provided with a groove secant and perpendicular to the duct, the cross-section of the groove being shaped to receive with interposition of a sealing means, the said channel with its orifice communicating with the duct a retaining means (47) keeping the channel in position in the groove.

6. Thermal connector according to any one of claims 3 and 5, characterized in that the duct is extended between the hole or the groove and the end of the block by a duct portion designed to receive means (30) for clamping the channel (31, 41) in position.

7. Thermal connector according to any one of claims 1 to 6, characterized in that the face of the board opposite that in contact with the wall is in contact with holding means (7, 8), which are fast with the connector, and apply said face against said wall.

## Patentansprüche

1. Thermischer Verbinder für eine gedruckte Schaltungkarte (11), wobei die Karte mindestens eine Wärme abgebende elektronische Komponente (2) trägt und ein thermoleitendes Substrat (5) besitzt, und wobei ferner der Verbinder folgendes aufweist: mindestens eine in einem thermisch gut leitendem Material realisierte Wand (10) an der ein Teil (9) des thermoleitenden Substrats in direktem Kontakt aufgenommen ist, und mindestens eine Leitung (15) für die Zirkulation eines Wärmeträgerfluids,
dadurch gekennzeichnet,
daß der Verbinder die Form eines lang gestreckten Teils besitzt, in dem die Wand (10) um einen Block (14) verlängert ist und mit diesem ein Monoblockensemble bildet,
daß sich die Leitung (15) in Längsrichtung in dem Block (14) erstreckt,

daß der Verbinder eine einzige Karte aufnimmt und individuelle Mittel aufweist zur in Positionhaltung auf einem Träger, und daß der Verbinder mindestens ein Fluidzuführmittel in Verbindung mit der Leitung (15) und mindestens ein Fluidabführmittel in Verbindung mit der Leitung (15) aufweist, wobei die genannten Mittel mit Fluidzufuhr- und Fluidabfuhrkanälen (22, 23) in Verbindung stehen.

2. Thermischer Verbinder nach Anspruch 1, dadurch gekennzeichnet, daß die die Zirkulation eines Wärmeträgerfluids gestattenden Mittel durch mindestens eine in den Block gebohrte Leitung (15) gebildet sind.

3. Thermischer Verbinder nach Anspruch 2, dadurch gekennzeichnet, daß zur Realisierung der Fluidverbindung zwischen jeder Leitung und einem der Wärmeträgerströmungsmittelzuführ- oder -abführkanäle, der Kanal (31) mit mindestens einer Öffnung (32) ausgestattet ist, und zwar mit einem Durchmesser im wesentlichen gleich dem Durchmesser der Leitung (13) und der Block weist ein Loch (33) auf, und zwar mit einem Durchmesser größer als der des Kanals, die Leitung schneidend und senkrecht dazu verlaufend, wobei das Loch unter Zwischenschaltung eines Dichtungsmittels (34) zur Aufnahme eines der Kanäle derart dient, daß die Öffnung des Kanals (32) in Verbindung mit der Leitung (15) steht.

4. Thermischer Verbinder nach Anspruch 3, dadurch gekennzeichnet, daß die Dichtmittel durch eine Ringverbindung (34) gebildet sind, angeordnet auf einer Wand einer Öffnung (35) mit einem Durchmesser im wesentlichen gleich dem Durchmesser der Öffnung des Kanals.

5. Thermischer Verbinder nach Anspruch 3, dadurch gekennzeichnet, daß zur Realisierung der Fluidverbindung zwischen jeder Leitung und einem der Wärmeträgerfluidzuführ und -abführkanäle die Kanäle (41) durch Rohre gebildet sind, und zwar mit einem rechteckigem oder quadratischem Querschnitt ausgerüstet an einer Stirnfläche mit mindestens einer Öffnung (42) mit einem Durchmesser im wesentlichen gleich dem Durchmesser der Leitung (15), und wobei der Block mit einem die Leitung schneidend und senkrecht dazu verlaufenden Einschnitt ausgestattet ist, wobei ferner der Schnitt des Einschnitts unter Zwischenlage von Dichtungsmitteln die Aufnahme des Kanals mit seiner Öffnung mit der Leitung in Verbindung stehend gestattet, und wobei schließlich Haltemittel (47) den Kanal in dem Einschnitt halten.

6. Thermischer Verbinder nach einem der Ansprüche 3 bis 5, dadurch gekennzeichnet, daß die Leitung sich zwischen dem Loch oder dem Einschnitt und dem Ende des Blocks um einen Leitungsteil verlängert, der bestimmt ist ein Mittel (30) aufzunehmen, welches die Befestigung des Kanals (31, 41) in Position gestattet.

7. Thermischer Verbinder nach einem der Ansprüche 1 bis 6, dadurch gekennzeichnet, daß die Stirnfläche der Karte entgegensetzt zu der Stirnfläche die in Berührung mit der Wand steht, in Kontakt ist mit, mit dem Verbinder solidarischen Haltemitteln (7, 8), welche die Karte gegen die Wand halten.

# FIG_2

# FIG_1

S

17

17'

17''

17''

23

6

22

22

E 21

16

20

11

19''

6

19

22

23

21

19''

19'

18

22

E

11

1

3

2

4

5

9

8

6

10

13

7

14

15

EP 0 199 621 B1

# FIG_3

# FIG_4

# FIG_5

# FIG_6-a

# FIG_6-b

EP 0 199 621 B1

# FIG_6-c